# EUROPEAN PATENT SPECIFICATION

(11) **EP 4 160 919 B1**
(45) Date of publication and mention of the grant of the patent: **24.07.2024**
(21) Application number: 21200141.6
(22) Date of filing: 30.09.2021
(51) Int. Cl.: H03K 17/0416, H03K 17/06

(54) **BACK BIAS GENERATOR CIRCUIT**
SCHALTUNG FÜR BACK-BIAS-GENERATOR
CIRCUIT GÉNÉRATEUR DE POLARISATION ARRIÈRE

(43) Date of publication of application: 05.04.2023
(73) Proprietor: Fraunhofer-Gesellschaft zur Förderung der angewandten Forschung e.V., 80686 München (DE)
(72) Inventor: AGASHE, Bangalore Ramesh Akshay, 91058 Erlangen (DE); HERZER, Elmar, 91058 Erlangen (DE)
(74) Representative: Gagel, Roland

(56) References cited:
- WO-A2-2007/012993
- US-A- 6 097 113
- US-A1- 2016 056 780

## Description

### Technical Field

The present invention relates to a back bias generator circuit having a digital to analog converter (DAC) and a control unit for the digital to analog converter, the generator circuit generating an output voltage at an output terminal based on a digital input.

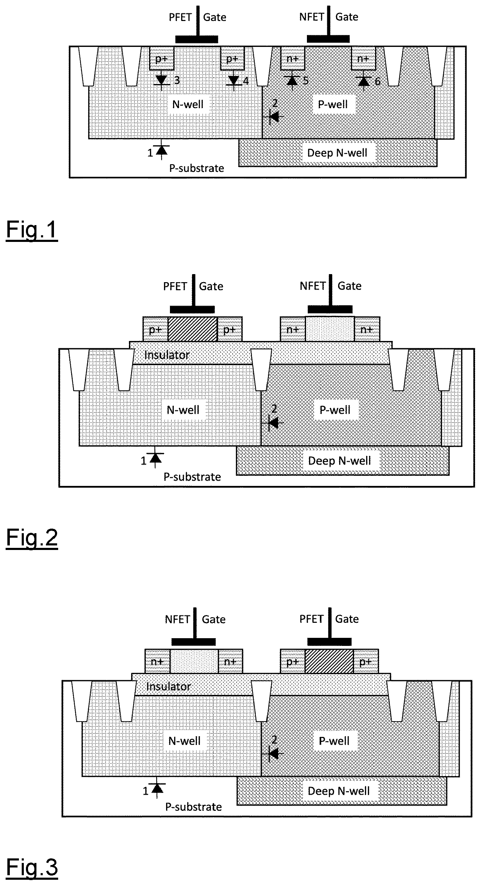

Back Bias Generators (BBG) are circuits used to provide the back-gate biasing voltages to improve the transistor performance. The conventional bulk planar MOS transistor architecture is shown in the Figure 1. The MOS transistor is a four-terminal device, namely gate, source, drain and bulk. The bulk, also known as back-gate is the terminal connected to the well on which the channel is formed. The threshold voltage of the MOS transistor can be varied by changing the back-gate voltage (effectively the voltage of the well). This variation of the threshold voltage with back-gate biasing can be used to control the performance of the MOS device in terms of speed or leakage. However, the voltage range that can be applied to the back-gate terminal in a conventional bulk planar MOS transistor is majorly limited by the junction diode between source/drain and the well. The reverse bias condition of diodes 3, 4, 5 and 6 in Figure 1, limit the range of the back-gate voltage that can be applied. Hence, in conventional bulk planar MOS architecture the use of back-gate biasing for improving the device performance is rarely used.

On the other hand, the SOI architecture (SOI: Silicon on Insulator), as shown in Figure 2, is a planar process technology, similar to the bulk technology, with an additional insulator (Buried Oxide) layer. The insulator layer underneath the channel isolates the source/drain from the well, which improves considerably the range of the back gate voltages that can be applied, as the problem of forward biasing diodes between the well and source/ drain is eliminated. Comparing Figure 1 and Figure 2, the junction diode between the source/drain and the well in the bulk planar MOS architecture is not present in the SOI MOS architecture. Hence, the limits of the back bias voltages that can be applied to a device are defined by diodes 2 between the wells and the diode 1 between the well and substrate.

Considering a forward bias voltage of 0.3 V for the junction diode, the diode 1 between N-well and substrate is forward biased when the voltage on N-well is 0.3 V lesser than the substrate voltage. Generally, in most cases the substrate voltage is 0 V. Hence, the back-gate of N-well should always be greater than -0.3 V to avoid the forward biasing of the junction diode 1. Similarly, the junction diode 2 between the P-well and N-well is forward biased when P-well voltage is 0.3 V greater than the N-well voltage. Considering a N-well voltage of 0 V, the P-well voltage should be lesser than 0.3 V to avoid the forward biasing of the junction diode. Higher values of P-well voltages are allowed if the voltage on the underlying N-well (deep N-well) is also increased. For example, a P-well voltage of 1.5 V would still not cause the forward biasing of junction diode if the deep N-well is at 1.8 V. This would mean that each device having higher voltage on P-well should have a separate deep N-well at an even higher potential. A separate deep N-well will eventually increase the area and the voltage on underlying N-well will be dependent on the P-well voltage. Hence, in most cases the upper limit for P-well is 0.3 V and lower limit for N-well is -0.3 V. The lower limit of P-well voltage and the upper limit of N-well voltage are limited by the breakdown voltage of reverse biased voltage of junction diode. The typical value of reverse breakdown is in the order of few volts (>2-3 V). Hence, a reasonable range for P-well is -2 V to +0.3 V and -0.3 V to +2 V for N-well (see e.g., S. Höppner et al., "How to Achieve World-Leading Energy Efficiency using 22FDX with Adaptive Body Biasing on an Arm Cortex-M4 IoT SoC," ESSDERC 2019 - 49th European Solid-State Device Research Conference (ESSDERC), 2019, pp. 66-69).

The two modes of back-gate bias that can be applied to the SOI architecture are FBB (Forward Body Biasing, Figure 3) and RBB (Reverse Body Biasing, Figure 2). The FBB occurs when a positive bias voltage is applied on the back-gate of NFET or a negative voltage is applied on the back-gate of PFET. In FBB operation, the back-gate bias works with the primary gate voltage which reduces the threshold voltage. The reduction in the threshold voltage allows faster switching capabilities of the device. The RBB occurs when a negative bias voltage is applied on back-gate of NFET or a positive voltage is applied on back-gate of PFET. In RBB operation, the back-gate bias works against the primary gate voltage which increases the threshold voltage. The increased threshold voltage reduces the current leakage in the device. Hence, by applying the suitable back-gate bias to the device the performances like switching speed and leakage can be controlled. The performance of device can be varied in run time by dynamically changing the back-gate bias of the device to allow a trade off, for example, between power consumption and speed depending on the requirement. This results in the need of a circuit that generates different back-gate or back bias voltages to vary the performance of the device, i.e. a BBG circuit. To control the P-well and N-well independently, separate BBG circuits are used. In most of the digital applications, the BBG generates voltages that are applied to large areas of wells called well islands. The well islands are capacitive in nature and the capacitance of the well increases with the well area. Therefore, the load for the BBG circuit is mostly capacitive as the resistance of the well is very high.

### Prior Art

BBG architectures can be broadly classified based on the use case (application) or the implementation topology.

Regarding the use case, BBG circuits can be subdivided in adaptive and non-adaptive systems. In adaptive systems, the BBG adapts its output to have a specific performance, like a particular frequency of a signal or a delay of a signal, over process, voltage and temperature (PVT) variations. In that case, the BBG will have an inherent PVT monitor circuit. Since the output of the BBG will be in a control loop, an absolute output voltage cannot be directly set by the input. Hence, in the adaptive systems the loop guarantees a particular performance over corners and not a specific output voltage at the BBG. On the contrary, the dynamic or static systems (non-adaptive systems) generate a specific output voltage for a given input code similar to a digital to analog converter. S. Nedelcu et al., "Dynamic body bias for 22nm FD-SOI CMOS Technology", ANALOG 2016; 15. ITG/GMM-Symposium, pp. 1-5, Sept 2016., A. Siddiqi et al., "Back-bias generator for post-fabrication threshold voltage tuning applications in 22nm FD-SOI process", 19th International Symposium on Quality Electronic Design (ISQED), Santa Clara, CA, 2018, pp. 268-273, or US 2020/0117226 A1 show examples for non-adaptive systems. If the well voltage can be changed during the system operation, then the BBG is termed as dynamic. On the other hand, if the well voltage cannot be changed during system operation, the BBG is termed as static. The back biased circuits, like digital standard cells, are characterized for certain performance at a given well voltage. Therefore, it is desirable to be able to set an absolute voltage on the well for a given input code during the system operation. The BBG circuit of the present invention is of the non-adaptive dynamic type.

Regarding the implementation topology, the BBG can either be an open loop system or a closed system. The open loop structure consists of a charge pump that sets the reference of the digital to analog converter (see e.g., above mentioned publication of A. Siddiqi et al. and US 2020/0117226 A1). The DAC is followed by a buffer to drive the wells. For a closed loop control, there are two possible types: analog control loop and digital control loop. In the former, the output of the BBG is regulated using an analog circuit like a comparator. Whereas for the latter, digital or pseudo digital circuits like delay lock loop (DLL) are used in the control loop. The area overhead in closed loop systems is increased due to the additional blocks in the control loop. However, the static power consumption can be reduced in the closed loop structures with better regulation of the output voltage. The BBG circuit of the present invention has a non-adaptive open loop architecture so that the BBG circuit generates an absolute voltage based on the input code at minimum area overhead.

Most of the existing open loop architectures generate output voltages within the supply voltage and generate either positive voltages for N-well or negative voltages for P-well. Although, the circuit in US 2020/0117226 A1 produces bipolar output voltages, the output voltage does not exceed supply voltage of 1.8 V. The publication of S. Höppner et al., "Adaptive Body Bias Aware Implementation for Ultra-Low-Voltage Designs in 22FDX Technology", in: IEEE Transactions on Circuits and Systems II: Express Briefs, vol. 67, no. 10, pp. 2159-2163, Oct. 2020, describes a BBG circuit generating voltages above 1.8 V and below 0 V for N-well and above 0 V and below 1.8 V for P-well. However, this architecture is adaptive in nature.

US 2016/056780 A1 is also considered relevant prior art and discloses a bulk bias generation circuit comprising a resistor string where the higher voltage is a boosted power supply and the lower voltage is a negative voltage with respect to ground.

It is an object of the present invention to provide a back bias generator circuit which is able to generate an output voltage exceeding the upper and lower limits (upper supply rail and lower supply rail) of the supply voltage and which allows an area efficient implementation.

### Description of the Invention

The object is achieved with the back bias generator circuit according to claim 1. Advantageous configurations of this circuit are subject of the dependent claims or can be identified in the subsequent description and exemplary embodiments.

The proposed back bias generator circuit at least comprises a special purpose digital to analog converter (DAC) generating an output voltage at an output terminal based on a digital input to the circuit, an upper and a lower switched capacitor circuit, and a control unit for the DAC and switched capacitor circuits. In addition to the output terminal, the DAC has at least six further terminals, which are named as follows to distinguish them: an upper supply terminal and a lower supply terminal for applying an upper supply voltage VDD and a lower supply voltage VSS, respectively, an upper input terminal, a lower input terminal, as well as a lower terminal and an upper terminal. The DAC is formed of a resistor string and a switching network of several switching transistors which are arranged to allow a tapping of a voltage at selectable locations of the resistor string and at the upper and lower input terminals and to pass the tapped voltage to the output terminal, the resistor string being connected between the upper supply terminal and the lower supply terminal. The uppermost resistor or the uppermost or combination of resistors in series of the resistor string is with its upper end directly connected to the upper supply terminal and with its lower end via the lower terminal to the upper switched capacitor circuit. The lowermost resistor of the resistor string or the lowermost combination of resistors in series is with its lower end directly connected to the lower supply terminal and with its upper end via the upper terminal to the lower switched capacitor circuit. Preferably, said uppermost and lowermost resistors (or a resistor of said combination of resistors in series) are formed of variable resistors. This allows an adjustment of the extended upper voltage and extended lower voltage without having to substitute these resistors with other resistors. The upper switched capacitor circuit and the lower switched capacitor circuit are designed to generate and supply an extended upper voltage to the upper input terminal of the DAC and an extended lower voltage to the lower input terminal of the DAC. The extended upper voltage exceeds the upper supply voltage by the voltage difference between the upper supply voltage and the voltage at the lower terminal. The extended lower voltage undercuts the lower supply voltage by the voltage difference between the voltage at the upper terminal and the lower supply voltage.

The terms upper and lower in connection with the components of the proposed circuit do not mean any geometric relation in the present patent application but only serve to distinguish between different ends of the resistor string and resistors, between different terminals and between the switched capacitor circuits.

The proposed back bias generator circuit has a non-adaptive open loop BBG architecture and generates bipolar output voltages, the upper and lower values of these output voltages, i.e. the extended upper voltage and extended lower voltage, exceeding the upper and lower limits of the supply voltage. For example, in case of a supply voltage of 1.8 V (upper supply rail 1.8 V, lower supply rail 0 V) an output voltage range that goes beyond 1.8 V and below 0 V is achieved which can be used for biasing the N-well of a SOI MOS transistor. For biasing the P-well, the output voltage of the DAC of the proposed circuit is inverted by an appropriate converter to provide mostly negative voltages.

In a preferred embodiment, the switching transistors of the DAC comprise PMOS transistors and NMOS transistors which are arranged such in the switching network that higher values of the tapped voltage are passed to the output terminal with PMOS transistors, and lower values of the tapped voltage are passed to the output terminal with NMOS transistors. Preferably, the higher values of the tapped voltage are voltages ≥ or > half of the upper supply voltage and the lower values of the tapped voltage are voltages < or ≤ half of the upper supply voltage. This minimizes the area required for forming the switching network.

In an advantageous embodiment of the proposed circuit, also in combination with other preferred embodiments, the switching transistors of the switching network are specified for the supply voltage only, and not for the exceeded voltage range (relating to the specification of the maximum gate-source voltage). This also saves area for forming the proposed circuit. In order to avoid stress on the gates of the switching transistors which might destroy the transistors, the control unit in this or a further embodiment is designed to generate the control signals with different high and/or low levels dependent on the location of the switching transistors in the switching network and/or on the input code such that the gate-source voltage of the switching transistors never exceeds a voltage difference ΔV existing between the upper supply voltage and the lower supply voltage.

The simple architecture and the open loop topology of the proposed back bias circuit results in an area efficient solution. The area efficient BBG blocks can be included in the IO pad ring of the chip and power supply from the IO ring can be shared. This eliminates the overhead due to the BBG block as the core area of the chip is not used for the BBG block. Multiple units of the BBG blocks can be placed in the IO ring to obtain higher drive strengths for larger well areas. The BBG circuits can be realized with transistors capable to handle 1.8 V, for example, although the output voltage exceeds the range of 0 V to 1.8 V.

By having a non-adaptive architecture that generates an extended range of bipolar output voltages, further performance enhancement of the devices with back bias is possible and absolute voltages can be set on the wells. The proposed BBG circuit is preferably used to provide the back bias to transistors, in particular MOS transistors. The circuit may however also be used for other applications or elements requiring such an extended voltage range.

### Brief Description of the Drawings

The proposed BBG circuit is described in the following by means of exemplary embodiments and corresponding figures. The figures show:
- Fig. 1: an example of the bulk CMOS architecture with a PMOS transistor in N-well and a NMOS transistor in P-well;
- Fig. 2: an example of a conventional well SOI architecture with a NMOS transistor above P-well and a PMOS transistor above N-well;
- Fig. 3: an example of a flip well SOI architecture with a PMOS transistor above P-well and a NMOS transistor above N-well;
- Fig. 4: an example of the special purpose DAC of the proposed BBG circuit;
- Fig. 5: a schematic view of the components of an example of the proposed BBG;
- Fig. 6: a schematic view of an exemplary control unit of the proposed BBG, with digital logic, non-overlapping clock generator and level shifter array block;
- Fig. 7: a highly schematic view of an example of the proposed BBG for back biasing the N-well;
- Fig. 8: a highly schematic view of an example of the proposed BBG for back biasing the P-well; and
- Fig. 9: an example of a modified 1:-1 switched capacitor charge pump (voltage converter) for inverting the output voltage of the proposed BBG.

### Detailed Description of Embodiments

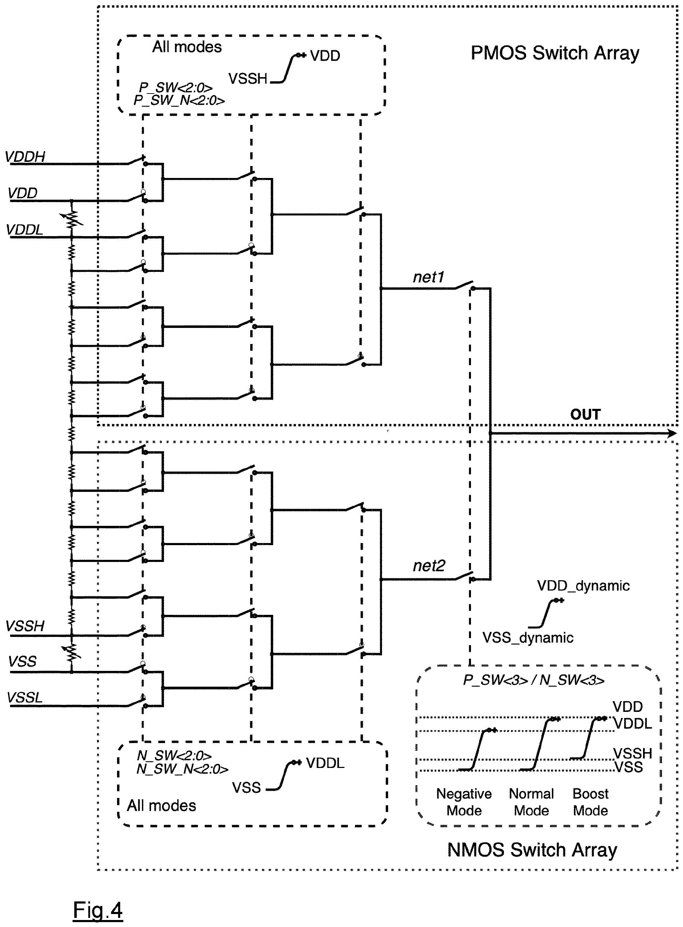

The proposed BBG at least comprises a special purpose DAC, an upper and a lower switched capacitor circuit, and a control unit for the DAC and switched capacitor circuits. An example of the special purpose DAC is shown in Figure 4. This DAC is formed of a resistor string DAC with modifications to allow voltages above the upper supply rail (VDD) and below the lower supply rail (VSS). This DAC can operate in three modes: Normal, Negative and Boost. In Normal mode, the DAC operates as a traditional resistor string DAC generating voltages from VSS to VDD. An output voltage higher than VDD (VDDH) is generated in boost mode. Similarly, an output voltage lower than VSS (VSSL) is generated in negative mode. The value of voltage to be generated in boost mode and negative mode is set by the variable resistor in the top (uppermost resistor) and bottom (lowermost resistor) of the resistor string respectively. The one end of the top resistor is connected to vdd and the other end is connected to net vddl. In the present description, the value of voltage is represented in upper case (see Figure 4) and the lower case of voltage value is used to represent the net name. For example, VDD is the voltage value, and the corresponding net name is vdd. The bottom resistor is connected to vss and the other end is connected to vssh. The values of these resistors are preferably equal so that the magnitude of voltage above the supply rail is equal to the magnitude of voltage below the supply rail. Voltage at net vddl (VDDL) is always less than voltage at net vdd (VDD). Similarly, the voltage at net vssh (VSSH) is always greater than the voltage at net vss (VSS). The voltage difference between vdd and vddl is used to generate VDDH, the voltage above the upper supply rail. The voltage difference between vssh and vss is used to generate VSSL, the voltage below the lower supply rail. The generation of voltages at net vddh and vssl using the existing voltages VDD, VSS, VDDL and VSSH from the resistor string will be explained below.

In this example, the higher values of the resistor string DAC are passed to the output with PMOS transistors, and the lower values are passed with NMOS transistors to minimize the area as compared to using transmission gate for all switches. An important consideration when the outputs go beyond the supply voltage is the stress on the gate of the switching transistors, if these transistors are not specified for the higher voltage differences. If the V_{GS} (gate source voltage) of the transistor goes beyond the allowed limits it can lead to degradation of the transistor performance or a complete failure of the device. Hence, it is very important to keep the transistor gate stress free when operating beyond the supply rails.

In a conventional resistor string DAC, the high and low levels of control signals to all the switching transistors are at VDD and VSS respectively. However, in this implementation different high and low levels of control signals are used based on the transistor location in the matrix or switching network and the switch type. The net out of the DAC can range from VSSL to VDDH. Hence, the high and low levels of control signals of the switching transistors at the output, out, cannot be at VDD or VSS for all modes. Instead, they are at VDD_dynamic and VSS_dynamic. The value of VDD_dynamic and VSS_dynamic is defined by the mode in which the DAC is operating (Normal, Negative, Boost).

In normal mode, the net out ranges from VSS to VDD and hence the VDD_dynamic and VSS_dynamic would be equal to VDD and VSS respectively. In negative mode, the net out goes below the supply rail to VSSL. In this case, the VDD_dynamic and VSS_dynamic is equal to VDDL and VSS respectively. The high level of the control signals of the switching transistors is reduced in this mode to VDDL and the low level of the control signal is kept at VSS. Even though the output net, out, goes below VSS there is no V_{GS} violation as the high level of the control signal of the switch is also reduced. Similarly, in boost mode the net out goes above the supply rail to VDDH. In this case, the VDD_dynamic and VSS_dynamic is equal to VDD and VSSH respectively. The low level of the control voltage of the switching transistors is increased in this mode to VSSH and the high level of the control voltage is kept at VDD. Even though the output net, out, goes above VDD, there is no V_{GS} violation as the low level of the control signal of the switching transistor is also increased. Considering net 1 of Figure 4, the voltage at this net can go beyond VDD and never below VSS, as all the switching transistors in this PMOS switch array would be OFF in negative mode. Hence, the high and low levels of control signals to all the switching transistors to the left of net 1 are at VDD and VSSH respectively. Considering net 2 of Figure 4, the voltage at this net can go below VSS and never above VDD, as all the switching transistors this in NMOS switch array would be OFF in boost mode. Hence, the high and low levels of control voltages to all the switching transistors to the left of net 2 are at VDDL and VSS respectively. Therefore, by varying the high and low levels provided to control the switching transistors, the proposed special purpose DAC allows output voltages beyond the supply rails without any gate stress. The generation of the control signals for the switching transistors in the special purpose DAC is explained in the following.

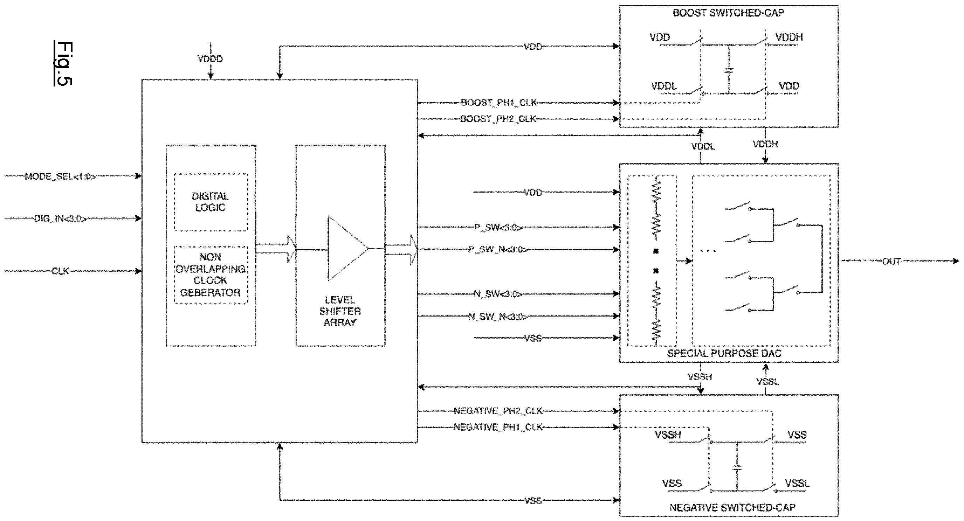

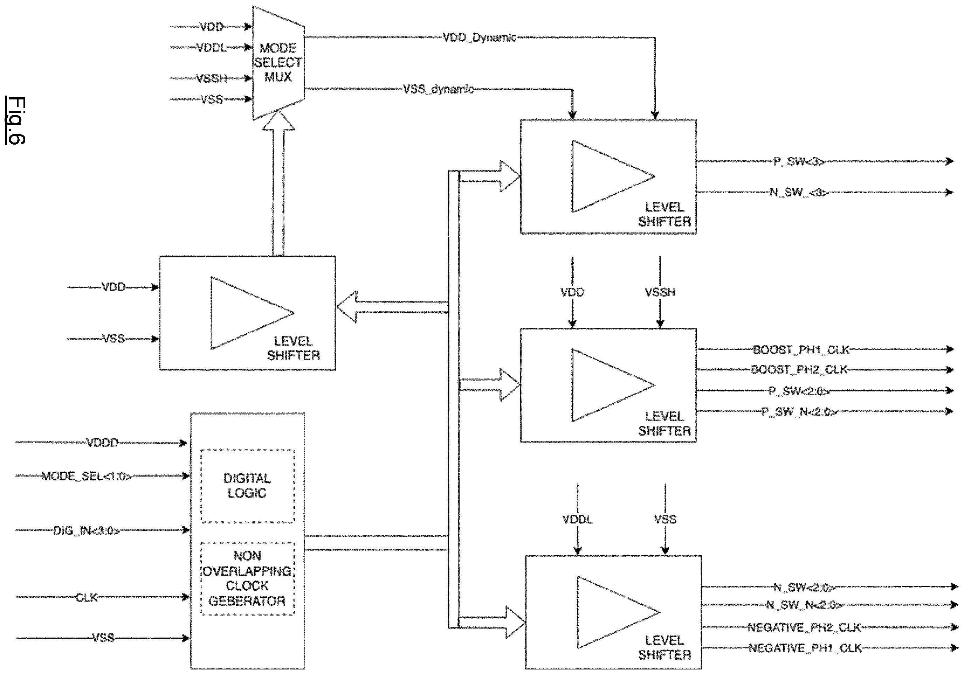

An example of a non-adaptive open loop BBG circuit with the special purpose DAC according to the present invention is shown in Figure 5. The BBG output, OUT, is set based on the 4-bit input code DIG_IN. The input CLK is used by the boost and negative switched-cap blocks (switched capacitor circuits). The 2-bit mode select, MODE_SEL, signal is used to define the mode of operation of the special purpose DAC and thereby the BBG. It would however also be possible to only use a digital input code without a mode select code and to select the required modes in the control unit dependent on the digital input code. The control unit of the BBG comprises a digital logic and a non-overlapping clock generator operating in this example at VDDD. Based on the input code and the mode select value, these blocks generate the appropriate control signals for the switching network in the special purpose DAC and the non-overlapping clocks for both boost and negative switched-cap blocks. Since in this implementation VDDD and VDD are at different values, 0.8 V and 1.8 V respectively, a level shifter array is added in between as part of the control unit to change the level of the signals generated. In a general case, the level shifter array would shift all the signals from VDDD domain to VDD domain. However, as explained above, the high and low levels of the control signals are not always VDD and VSS. Hence, level shifters with different supply voltages are used for different signals as exemplary shown in Figure 6.

The mode select signal is level shifted in VDD and VSS domain. The level shifted mode select signal is provided as select signal to the mode select MUX block. This block assigns the right value to VDD_dynamic and VSS_dynamic based on the mode of operation as already explained above. The level shifters operating in VDD and VSSH domain are used to generate the control signals to the switching transistors in the PMOS switch array (except the switching transistor connected to the output) and boost switched_cap block. The level shifters operating in VDDL and VSS domain are used to generate the control signals to the switching transistors in the NMOS switch array (except the switching transistor connected to the output) and negative switched_cap block. The level shifters operating in VDD_dynamic and VSS_dynamic domain are used to generate the control signals to the switching transistors connected to the output in the special purpose DAC.

The voltage above the upper supply rail VDD, is generated by the boost switched-cap block. The block samples the difference between VDD (net vdd) and VDDL (net vddl) in one phase and adds this difference to VDD in the next phase. Thereby generating a voltage above the upper supply rail, VDDH ~ (VDD+ (VDD-VDDL)). A two phase non-overlapping clock signal BOOST_PH1_CLK and BOOST_PH2_CLK are used in this block. Since the voltage in this block can go above the upper supply rails, the high and low levels of the non-overlapping clock signals are at VDD and VSSH to avoid any gate stress.

The voltage below the lower supply rail VSS, is generated by the negative switched-cap block. The block samples the difference between VSSH (net vssh) and VSS (net vss) in one phase and subtracts this difference from VSS in the next phase. Thereby generating a voltage below the lower supply rail, VSSL ~ (VSS - (VSSH-VSS)). A two phase non-overlapping clock signal (NEGATIVE_PH1_CLK and NEGATIVE _PH2_CLK) is used in this block. Since the voltage in this block can go below the lower supply rail, the high and low levels of the non-overlapping clock signals are at VDDL and VSS to avoid any gate stress. Hence a BBG that generates bipolar voltages ranging from VSSL to VDDH is implemented using the special purpose DAC. The typical output range of the BBG in this implementation is -0.2 V to +2 V. It generates 0.2 V above upper supply rail of 1.8 V and 0.2 V below lower supply rail of 0 V.

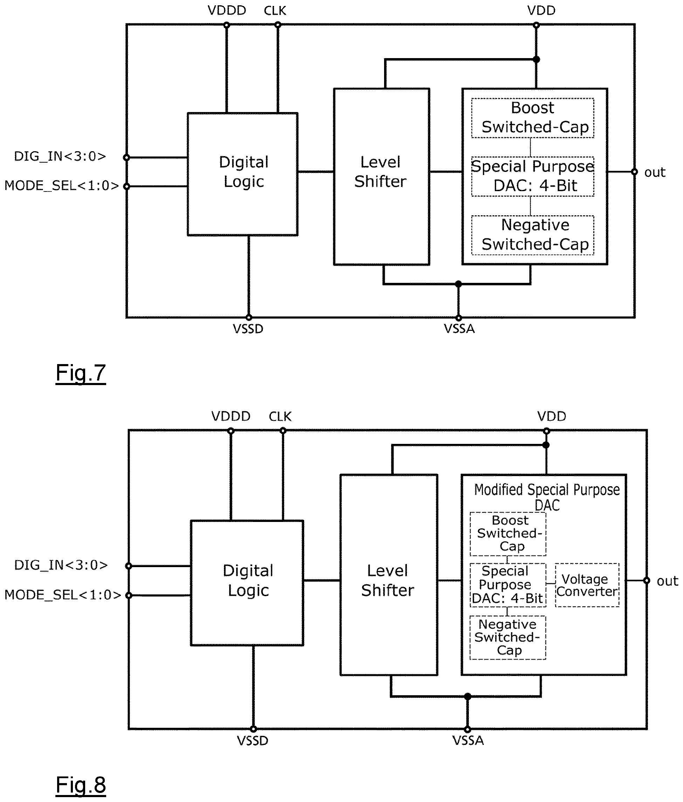

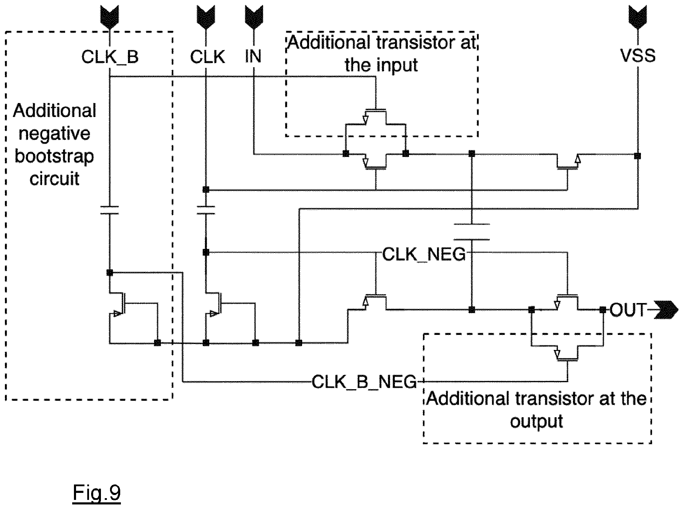

For back biasing a bulk MOS transistor as shown for example in Figure 2, a combination of two of the above BBG circuits is necessary. Such a system consists of separate BBG circuits to control N-well and P-well which are exemplary and highly schematic shown in Figure 7 and Figure 8. The BBG for N-well (BBGNW) is the circuit explained above generating predominantly positive voltage. The BBG for P-well (BBGPW), has to generate a similar voltage range but with opposite polarity. The BBGPW circuit thus consists of the BBGNW circuit followed by a voltage converter (modified 1:-1 converter, switched-capacitor charge pump) as exemplary shown in Figure 8, to generate predominantly negative voltages. A traditional 1:-1 converter as described e.g. in M. Blagojević et al., "A fast, flexible, positive and negative adaptive body-bias generator in 28nm FDSOI", 2016 IEEE Symposium on VLSI Circuits (VLSI-Circuits), Honolulu, 2016, pp. 1-2, is useful for converting high input voltages. However, in the present use case it is intended to have a conversion for both low and high inputs. Hence, two additional transistors, one at the input and the other at the output are added to allow the conversion of low input voltages as shown in Figure 9, because the switches operated by CLK and CLK_NEG will not conduct for low voltages. For the additional transistor at the input the inverted clock signal, CLK_B, can be used. However, for the new transistor at the output an additional negative gate drive signal, CLK_B_NEG, has to be generated. An additional negative bootstrap circuit is used to generate this signal. With this little modification, the modified 1:-1 converter is able to generate negative outputs for both low and high voltages at the input. Even for a negative input voltage, a positive output is obtained. Hence, the BBGPW can also generate bipolar output voltages. The control signals for the transistors in the 1:-1 converter preferably are having different high levels based on the input code similar to the switching transistors at the output of the DAC in one of the above described advantageous embodiments.

The above area efficient non-adaptive open loop BBG system generates bipolar output voltages on N-well and P-well to fully utilize the extended range of back-gate bias voltages. The BBG to generate negative voltages has a modified 1:-1 converter to generate an extended range of outputs as compared to the traditional 1:-1 converter. The special purpose DAC enables the boost and negative modes only when the required output voltages are beyond the supply rails. If the required output is within the supply rails, the special purpose DAC operates as a simple resistor string DAC.

## Claims

1. Back bias generator circuit at least comprising:
- a digital to analog converter (DAC) generating an output voltage (OUT) at an output terminal based on a digital input to the circuit,
- an upper and a lower switched capacitor circuit, and
- a control unit for the digital to analog converter (DAC) and switched capacitor circuits,
- wherein said digital to analog converter (DAC)
-- has an upper supply terminal (vdd) and a lower supply terminal (vss) for applying an upper supply voltage (VDD) and a lower supply voltage (VSS), respectively, an upper input terminal (vddh), a lower input terminal (vssl), a lower terminal (vddl) and an upper terminal (vssh), and
-- is formed of a resistor string and a switching network of several switching transistors which are arranged to allow a tapping of a voltage at selectable locations of the resistor string and at the upper and lower input terminals (vddh, vssl) and to pass the tapped voltage to the output terminal, the resistor string being connected between the upper supply terminal (vdd) and the lower supply terminal (vss), wherein
-- an uppermost resistor or combination of resistors in series of the resistor string with an upper end is directly connected to the upper supply terminal (vdd) and with a lower end via the lower terminal (vddl) to the upper switched capacitor circuit, and a lowermost resistor or combination of resistors in series of the resistor string with a lower end is directly connected to the lower supply terminal (vss) and with an upper end via the upper terminal (vssh) to the lower switched capacitor circuit, and
- wherein said upper switched capacitor circuit and said lower switched capacitor circuit being formed to generate and supply an extended upper voltage (VDDH) to the upper input terminal (vddh) of the digital to analog converter (DAC) and an extended lower voltage (VSSL) to the lower input terminal of the digital to analog converter (DAC), said extended upper voltage (VDDH) exceeding the upper supply voltage (VDD) by a voltage difference between the upper supply voltage (VDD) and a voltage (VDDL) at the lower terminal (vddl), said extended lower voltage (VSSL) undercutting the lower supply voltage (VSS) by a voltage difference between a voltage (VSSH) at the upper terminal (vssh) and the lower supply voltage (VSS).

2. Back bias generator circuit according to claim 1, **characterized in that**
the switching transistors comprise PMOS transistors and NMOS transistors which are arranged such in the switching network that higher values of the tapped voltage are passed to the output terminal with PMOS transistors, and lower values of the tapped voltage are passed to the output terminal with NMOS transistors.

3. Back bias generator circuit according to claim 2, **characterized in that**
the higher values of the tapped voltage are voltages ≥ half of the upper supply voltage (VDD) and the lower values of the tapped voltage are voltages < half of the upper supply voltage (VDD), or that the higher values of the tapped voltage are voltages > half of the upper supply voltage (VDD) and the lower values of the tapped voltage are voltages ≤ half of the upper supply voltage (VDD).

4. Back bias generator circuit according to one or several of claims 1 to 3,
**characterized in that**
said uppermost and said lowermost resistors or combination of resistors in series are or include variable resistors enabling an adjustment of the extended upper voltage (VDDH) and extended lower voltage (VSSL).

5. Back bias generator circuit according to one or several of claims 1 to 4,
**characterized in that**
said upper switched capacitor circuit is formed to sample the voltage difference between the upper supply voltage (VDD) and the voltage (VDDL) at the lower terminal (vddl) in one phase and adds this difference to the upper supply voltage (VDD) in the next phase, based on a two phase non-overlapping clock signal (BOOST_PH1_CLK, BOOST_PH2_CLK), thereby generating the extended upper voltage (VDDH), and that
said lower switched capacitor circuit is formed to sample the voltage difference between the voltage (VSSH) at the upper terminal (vssh) and the lower supply voltage (VSS) in one phase and subtracts this difference from the lower supply voltage (VSS) in the next phase, based on a two phase non-overlapping clock signal (NEGATIVE_PH1_CLK, NEGATIVE_PH2_CLK), thereby generating the extended lower voltage (VSSL).

6. Back bias generator circuit according to one or several of claims 1 to 5,
**characterized in that**
the control unit comprises sub-units to generate control signals for the switching transistors of the digital to analog converter (DAC) and non-overlapping clock signals for both switched capacitor circuits.

7. Back bias generator circuit according to claim 6, **characterized in that**
the control unit is designed to generate the control signals with different high and/or low levels dependent on the location of the switching transistors in the switching network and/or of the input code such that a gate-source voltage (V_{GS}) of the switching transistors never exceeds a voltage difference ΔV existing between the upper supply voltage (VDD) and the lower supply voltage (VSS).

8. Back bias generator circuit according to claim 7, **characterized in that**
the control unit comprises several level shifters to generate the control signals with different high and low levels.

9. Back bias generator circuit according to claim 7 or 8,
**characterized in that**
the switching transistors of the switching network are specified for maximum gate-source voltages of said voltage difference ΔV.

10. Back bias generator circuit according to one or several of claims 1 to 9,
further comprising a 1:-1 voltage converter connected to the output terminal of the digital to analog converter (DAC), said voltage converter inverting the output voltage (OUT) of the digital to analog converter (DAC).

11. Back bias generator circuit according to claim 10, **characterized in that**
the voltage converter comprises at least a first input transistor at an input and a first output transistor at an output, said first input transistor being controlled via a gate drive signal (CLK), said first output transistor being controlled via the negative gate drive signal (CLK_NEG), generated from the gate drive signal (CLK) via a first bootstrap circuit,
wherein the voltage converter comprises a second input transistor parallel to the first input transistor and a second output transistor parallel to the first output transistor, said second input transistor being controlled via the inverted gate drive signal (CLK_B), said second output transistor being controlled via the negative inverted gate drive signal (CLK_B_NEG), generated from the inverted gate drive signal (CLK_B) via a second bootstrap circuit.

12. Back bias generator circuit according to claim 10 or 11,
**characterized in that**
the voltage converter is designed to convert both, positive and negative input voltages from the digital to analog converter (DAC).

13. Back bias generator circuit according to claim 12, **characterized in that**
the control unit is designed to generate control signals for the transistors of the voltage converter with different high levels dependent on the input code such that a gate-source voltage (V_{GS}) of the transistors of the voltage converter never exceeds a voltage difference ΔV existing between the upper supply voltage (VDD) and the lower supply voltage (VSS).

## Patentansprüche

1. Back-Bias-Generatorschaltung, die mindestens Folgendes umfasst:
- einen Digital-Analog-Wandler (DAC), der auf der Grundlage einer digitalen Eingabe in die Schaltung eine Ausgangsspannung (OUT) an einem Ausgangsanschluss erzeugt,
- eine obere und eine untere Schaltkondensatorschaltung, und
- ein Steuerteil für den Digital-Analog-Wandler (DAC) und die Schaltkondensatorschaltungen,
- wobei der Digital-Analog-Wandler (DAC)
-- einen oberen Versorgungsanschluss (vdd) und einen unteren Versorgungsanschluss (vss) zum Anlegen einer oberen Versorgungsspannung (VDD) bzw. einer unteren Versorgungsspannung (VSS), einen oberen Eingangsanschluss (vddh), einen unteren Eingangsanschluss (vssl), einen unteren Anschluss (vddl) und einen oberen Anschluss (vssh) aufweist, und
-- aus einer Widerstandskette und einem Schaltnetzwerk aus mehreren Schalttransistoren gebildet ist, die so angeordnet sind, dass sie einen Abgriff einer Spannung an wählbaren Stellen der Widerstandskette und an den oberen und unteren Eingangsanschlüssen (vddh, vssl) ermöglichen und die abgegriffene Spannung an den Ausgangsanschluss weiterleiten, wobei die Widerstandskette zwischen dem oberen Versorgungsanschluss (vdd) und dem unteren Versorgungsanschluss (vss) angeschlossen ist, wobei
-- ein oberster Widerstand oder eine oberste Kombination von Widerständen in der Reihe der Widerstandskette mit einem oberen Ende direkt mit dem oberen Versorgungsanschluss (vdd) und mit einem unteren Ende über den unteren Anschluss (vddl) mit der oberen Schaltkondensatorschaltung verbunden ist, und ein unterster Widerstand oder eine unterste Kombination von Widerständen in der Reihe der Widerstandskette mit einem unteren Ende direkt mit dem unteren Versorgungsanschluss (vss) und mit einem oberen Ende über den oberen Anschluss (vssh) mit der unteren Schaltkondensatorschaltung verbunden ist, und
- wobei die obere Schaltkondensatorschaltung und die untere Schaltkondensatorschaltung so ausgebildet sind, dass sie eine erweiterte obere Spannung (VDDH) am oberen Eingangsanschluss (vddh) des Digital-Analog-Wandlers (DAC) und eine erweiterte untere Spannung (VSSL) am unteren Eingangsanschluss des Digital-Analog-Wandlers (DAC) erzeugen und zuführen, wobei die erweiterte obere Spannung (VDDH) die obere Versorgungsspannung (VDD) um eine Spannungsdifferenz zwischen der oberen Versorgungsspannung (VDD) und einer Spannung (VDDL) am unteren Anschluss (vddl) übersteigt und die erweiterte untere Spannung (VSSL) die untere Versorgungsspannung (VSS) um eine Spannungsdifferenz zwischen einer Spannung (VSSH) am oberen Anschluss (vssh) und der unteren Versorgungsspannung (VSS) unterschreitet.

2. Back-Bias-Generatorschaltung nach Anspruch 1,
**dadurch gekennzeichnet, dass**
die Schalttransistoren PMOS-Transistoren und NMOS-Transistoren umfassen, die in dem Schaltnetzwerk so angeordnet sind, dass höhere Werte der abgegriffenen Spannung mit PMOS-Transistoren an den Ausgangsanschluss geleitet werden und niedrigere Werte der abgegriffenen Spannung mit NMOS-Transistoren an den Ausgangsanschluss geleitet werden.

3. Back-Bias-Generatorschaltung nach Anspruch 2,
**dadurch gekennzeichnet, dass**
die höheren Werte der abgegriffenen Spannung Spannungen ≥ der Hälfte der oberen Versorgungsspannung (VDD) und die niedrigeren Werte der abgegriffenen Spannung Spannungen < der Hälfte der oberen Versorgungsspannung (VDD) sind, oder dass die höheren Werte der abgegriffenen Spannung Spannungen > der Hälfte der oberen Versorgungsspannung (VDD) und die niedrigeren Werte der abgegriffenen Spannung Spannungen ≤ der Hälfte der oberen Versorgungsspannung (VDD) sind.

4. Back-Bias-Generatorschaltung nach einem oder mehreren Ansprüchen 1 bis 3,
**dadurch gekennzeichnet, dass**
der/die oberste und der/die unterste Widerstand oder Kombination von Widerständen in Reihe veränderliche Widerstände sind oder einschließen, die eine Einstellung der erweiterten oberen Spannung (VDDH) und der erweiterten unteren Spannung (VSSL) ermöglichen.

5. Back-Bias-Generatorschaltung nach einem oder mehreren Ansprüchen 1 bis 4,
**dadurch gekennzeichnet, dass**
dass die obere Schaltkondensatorschaltung ausgebildet ist, um die Spannungsdifferenz zwischen der oberen Versorgungsspannung (VDD) und der Spannung (VDDL) am unteren Anschluss (vddl) in einer Phase abzutasten und diese Differenz zur oberen Versorgungsspannung (VDD) in der nächsten Phase zu addieren, basierend auf einem zweiphasigen nicht überlappenden Taktsignal (BOOST_PHl_CLK, BOOST_PH2_CLK), wodurch die erweiterte obere Spannung (VDDH) erzeugt wird, und dass die untere Schaltkondensatorschaltung ausgebildet ist, um die Spannungsdifferenz zwischen der Spannung (VSSH) am oberen Anschluss (vssh) und der unteren Versorgungsspannung (VSS) in einer Phase abzutasten und diese Differenz von der unteren Versorgungsspannung (VSS) in der nächsten Phase zu subtrahieren, basierend auf einem zweiphasigen nicht überlappenden Taktsignal (NEGATIVE_PHl_CLK, NEGATIVE_PH2_CLK), wodurch die erweiterte untere Spannung (VSSL) erzeugt wird.

6. Back-Bias-Generatorschaltung nach einem oder mehreren Ansprüchen 1 bis 5,
**dadurch gekennzeichnet, dass**
die Steuereinheit Untereinheiten zur Erzeugung von Steuersignalen für die Schalttransistoren des Digital-Analog-Wandlers (DAC) und von nicht überlappenden Taktsignalen für beide Schaltkondensatorschaltungen umfasst.

7. Back-Bias-Generatorschaltung nach Anspruch 6,
**dadurch gekennzeichnet, dass**
die Steuereinheit so ausgelegt ist, dass sie die Steuersignale mit unterschiedlichen High- und/oder Low-Pegeln in Abhängigkeit von der Lage der Schalttransistoren im Schaltnetz und/oder vom Eingangscode so erzeugt, dass eine Gate-Source-Spannung (V_{GS}) der Schalttransistoren niemals eine zwischen der oberen Versorgungsspannung (VDD) und der unteren Versorgungsspannung (VSS) bestehende Spannungsdifferenz ΔV überschreitet.

8. Back-Bias-Generatorschaltung nach Anspruch 7,
**dadurch gekennzeichnet, dass**
die Steuereinheit mehrere Pegelumsetzer umfasst, um die Steuersignale mit unterschiedlichen hohen und niedrigen Pegeln zu erzeugen.

9. Back-Bias-Generatorschaltung nach Anspruch 7 oder 8,
**dadurch gekennzeichnet, dass**
die Schalttransistoren des Schaltnetzes für maximale Gate-Source-Spannungen der genannten Spannungsdifferenz ΔV ausgelegt sind.

10. Back-Bias-Generatorschaltung nach einem oder mehreren Ansprüchen 1 bis 9,
die ferner einen 1:-1-Spannungswandler umfasst, der mit dem Ausgangsanschluss des Digital-Analog-Wandlers (DAC) verbunden ist, wobei der Spannungswandler die Ausgangsspannung (OUT) des Digital-Analog-Wandlers (DAC) invertiert.

11. Back-Bias-Generatorschaltung nach Anspruch 10,
**dadurch gekennzeichnet, dass**
der Spannungswandler mindestens einen ersten Eingangstransistor an einem Eingang und einen ersten Ausgangstransistor an einem Ausgang umfasst, wobei der erste Eingangstransistor über ein Gate-Treibersignal (CLK) gesteuert wird und wobei der erste Ausgangstransistor über das negative Gate-Treibersignal (CLK_NEG) gesteuert wird, das aus dem Gate-Treibersignal (CLK) über eine erste Bootstrap-Schaltung erzeugt wird,
wobei der Spannungswandler einen zweiten Eingangstransistor parallel zum ersten Eingangstransistor und einen zweiten Ausgangstransistor parallel zum ersten Ausgangstransistor umfasst, wobei der zweite Eingangstransistor über das invertierte Gate-Treibersignal (CLK_B) gesteuert wird, wobei der zweite Ausgangstransistor über das negative invertierte Gate-Treibersignal (CLK_B_NEG) gesteuert wird, das aus dem invertierten Gate-Treibersignal (CLK_B) über eine zweite Bootstrap-Schaltung erzeugt wird.

12. Back-Bias-Generatorschaltung nach Anspruch 10 oder 11, **dadurch gekennzeichnet, dass**
der Spannungswandler so konzipiert ist, dass er sowohl positive als auch negative Eingangsspannungen vom Digital-Analog-Wandler (DAC) umwandelt.

13. Back-Bias-Generatorschaltung nach Anspruch 12,
**dadurch gekennzeichnet, dass**
die Steuereinheit dazu ausgebildet ist, in Abhängigkeit vom Eingangscode Steuersignale für die Transistoren des Spannungswandlers mit unterschiedlich hohen Pegeln zu erzeugen, sodass eine Gate-Source-Spannung (V_{GS}) der Transistoren des Spannungswandlers niemals eine zwischen der oberen Versorgungsspannung (VDD) und der unteren Versorgungsspannung (VSS) bestehende Spannungsdifferenz ΔV überschreitet.

## Revendications

1. Circuit générateur de polarisation arrière comprenant au moins :
- un convertisseur numérique-analogique (DAC) générant une tension de sortie (OUT) au niveau d'une borne de sortie sur la base d'une entrée numérique du circuit,
- un circuit à condensateurs commutés supérieur et inférieur, et
- une unité de commande pour le convertisseur numérique-analogique (DAC) et les circuits à condensateurs commutés,
- dans lequel ledit convertisseur numérique-analogique (DAC)
-- possède une borne d'alimentation supérieure (vdd) et une borne d'alimentation inférieure (vss) pour appliquer respectivement une tension d'alimentation supérieure (VDD) et une tension d'alimentation inférieure (VSS), une entrée supérieure borne (vddh), une borne d'entrée inférieure (vssl) une borne inférieure (vddl) et une borne supérieure (vssh), et
-- est formé d'une chaîne de résistances et d'un réseau de commutation de plusieurs transistors de commutation qui sont disposés pour permettre une prise d'une tension à des emplacements sélectionnables de la chaîne de résistances et aux bornes d'entrée supérieure et inférieure (vddh, vssl) et pour transmettre la tension prélevée à la borne de sortie, la chaîne de résistances étant connectée entre la borne d'alimentation supérieure (vdd) et la borne d'alimentation inférieure (vss),
-- dans laquelle une résistance la plus haute ou une combinaison de résistances en série de la chaîne de résistances avec une extrémité supérieure est directement connectée à la borne d'alimentation supérieure (vdd) et avec une extrémité inférieure via la borne inférieure (vddl) au circuit à condensateurs supérieur commuté, et une résistance la plus basse ou une combinaison de résistances en série de la chaîne de résistances avec une extrémité inférieure est directement connectée à la borne d'alimentation inférieure (vss) et avec une extrémité supérieure via la borne supérieure (vssh) au circuit à condensateurd commuté inférieur, et
- dans lequel ledit circuit à condensateurs commuté supérieur et ledit circuit à condensateurs commuté inférieur sont formés pour générer et alimenter une tension supérieure étendue (VDDH) à la borne d'entrée supérieure (vddh) du convertisseur numérique-analogique (DAC) et une tension inférieure étendue (VSSL) à la borne d'entrée inférieure du convertisseur numérique-analogique (DAC), ladite tension supérieure étendue (VDDH) dépassant la tension d'alimentation supérieure (VDD) par une différence de tension entre la tension d'alimentation supérieure (VDD) et une tension (VDDL) à la borne inférieure (vddl), ladite tension inférieure étendue (VSSL) sous-cotant la tension d'alimentation inférieure (VSS) par une différence de tension entre une tension (VSSH) à la borne supérieure (vssh) et la tension d'alimentation inférieure (VSS).

2. Circuit générateur de polarisation arrière selon la revendication 1, **caractérisé en ce que** les transistors de commutation comprennent des transistors PMOS et des transistors NMOS qui sont agencés de sorte que dans la région de commutation où les valeurs supérieures de la tension prélevée sont transférées à la borne de sortie avec les transistors PMOS, et les valeurs inférieures de la tension prélevée sont transférées à la borne de sortie avec les transistors NMOS.

3. Circuit générateur de polarisation arrière selon la revendication 2, **caractérisé en ce que** les valeurs supérieures de la tension prélevée sont des tensions ≥ à la moitié de la tension d'alimentation supérieure (VDD) et les valeurs inférieures de la tension prélevée sont des tensions < à la moitié de la tension d'alimentation supérieure (VDD), ou que les valeurs supérieures de la tension prélevée sont des tensions > à la moitié de la tension d'alimentation supérieure (VDD) et les valeurs inférieures de la tension prélevée sont des tensions ≤ à la moitié de la tension d'alimentation supérieure (DDV).

4. Circuit générateur de polarisation inverse selon une ou plusieurs des revendications 1 à 3,
**caractérisé en ce que**
lesdites résistances les plus hautes et les plus basses ou une combinaison de résistances en série sont ou comprennent des résistances variables permettant un ajustement de la tension supérieure étendue (VDDH) et de la tension inférieure étendue (VSSL)

5. Circuit générateur de polarisation arrière selon une ou plusieurs des revendications 1 à 4, **caractérisé en ce que**
ledit circuit à condensateurs commutés supérieur est formé pour échantillonner la différence de tension entre la tension d'alimentation supérieure (VDD) et la tension (VDDL) au niveau de la borne inférieure (vddl) dans une phase et additionne cette différence à la tension d'alimentation supérieure (VDD) dans la phase suivante, sur la base d'un signal d'horloge biphasé sans chevauchement (BOOST _PH1_CLK, BOOST_PH2_CLK), en générant ainsi la tension supérieure étendue (VDDH), et que ledit circuit à condensateurs commutés inférieur est formé pour échantillonner la différence de tension entre la tension (VSSH) au niveau de la borne supérieure (vssh) et la tension d'alimentation inférieure (VSS) dans une phase et soustrait cette différence de la tension d'alimentation inférieure (VSS) dans la phase suivante, sur la base d'un signal d'horloge biphasé sans chevauchement (NEGATIVE_PH1_CLK, NEGATIVE_PH2_CLK), générant ainsi la tension inférieure étendue (VSSL)

6. Circuit générateur de polarisation arrière selon une ou plusieurs des revendications 1 à 5, **caractérisé en ce que** l'unité de commande comprend des sous-unités pour générer des signaux de commande pour les transistors de commutation du convertisseur numérique-analogique (DAC) et des signaux d'horloge sans chevauchement pour les deux circuits à condensateurs commutés.

7. Circuit générateur de polarisation arrière selon la revendication 6, **caractérisé en ce que**
l'unité de commande est conçue pour générer les signaux de commande avec différents niveaux haut et/ou bas en fonction de l'emplacement des transistors de commutation dans le réseau de commutation et/ou du code d'entrée de telle sorte qu'une tension grille-source (V_{GS}) des transistors de commutation ne dépasse jamais une différence de tension ΔV existant entre la tension d'alimentation supérieure (VDD) et la tension d'alimentation inférieure (VSS)

8. Circuit générateur de polarisation arrière selon la revendication 7, **caractérisé en ce que**
l'unité de commande comprend plusieurs décaleurs de niveau pour générer les signaux de commande avec différents niveaux haut et bas.

9. Circuit générateur de polarisation arrière selon la revendication 7 ou 8, **caractérisé en ce que** les transistors de commutation du réseau de commutation sont spécifiés pour des tensions grille-source maximales égales à ladite différence de tension ΔV.

10. Circuit générateur de polarisation arrière selon une ou plusieurs des revendications 1 à 9, comprenant en outre un convertisseur de tension 1:-1 connecté à la borne de sortie du convertisseur numérique-analogique (DAC), ledit convertisseur de tension inversant la tension de sortie (OUT) du convertisseur numérique-analogique (DAC).

11. Circuit générateur de polarisation arrière selon la revendication 10, **caractérisé en ce que**
le convertisseur de tension comprend au moins un premier transistor d'entrée au niveau d'une entrée et un premier transistor de sortie au niveau d'une sortie, ledit premier transistor d'entrée est commandé via un signal de commande de grille (CLK), ledit premier transistor de sortie étant commandé via le signal de commande de grille négatif (CLK NEG), généré à partir du signal de commande de grille (CLK) via un premier circuit bootstrap,
dans lequel le convertisseur de tension comprend un deuxième transistor d'entrée parallèle au premier transistor d'entrée et un deuxième transistor de sortie parallèle au premier transistor de sortie, ledit deuxième transistor d'entrée étant commandé via le signal de commande de grille inversé (CLK_B), ledit deuxième transistor de sortie étant commandé via le signal de commande de grille inversé négatif (CLK_B_NEG), généré à partir du signal de commande de grille inversée (CLK_B) via un deuxième circuit bootstrap.

12. Circuit générateur de polarisation arrière selon la revendication 10 ou 11,
**caractérisé en ce que**
le convertisseur de tension est conçu pour convertir les tensions d'entrée positives et négatives du convertisseur numérique-analogique (DAC).

13. Circuit générateur de polarisation arrière selon la revendication 12, **caractérisé en ce que** l'unité de commande est conçue pour générer des signaux de commande pour les transistors du convertisseur de tension avec différents niveaux élevés en fonction du code d'entrée de telle sorte qu'une tension grille-source (VGS) des transistors du convertisseur de tension ne dépasse jamais une différence de tension ΔV existant entre la tension d'alimentation supérieure (VDD) et la tension d'alimentation inférieure (VSS).
